# EUROPEAN PATENT APPLICATION

(11) **EP 4 625 178 A1**
(43) Date of publication of application: **01.10.2025**
(21) Application number: 24167169.2
(22) Date of filing: 28.03.2024
(51) Int. Cl.: G06F 11/36

(54) **A METHOD FOR GENERATING A SIMULATION CODE TO TEST A CONTROL LOGIC CODE**

(71) Applicant: ABB SCHWEIZ AG, 5400 Baden (CH)
(72) Inventor: KOZIOLEK, Heiko, 76227 Karlsruhe (DE); SCHOCH, Nicolai, 69120 Heidelberg (DE); GRUENER, Sten, 69514 Laudenbach (DE); TAN, Ruomu, 68163 Mannheim (DE); ASHIWAL, Virendra, 68542 Heddesheim (DE); BORRISON, Reuben, 68782 Brühl (DE)
(74) Representative: Maiwald GmbH

(57) **Abstract**

A method for generating a simulation code (190) to test a control logic code (160) is described , wherein the control logic code (160) is configured for controlling an automated industrial process, the method comprising:
providing the control logic code (160), wherein the control logic code (160) comprises identifiers, which are related to a plurality of components of the automated industrial process;
generating a simulation generation prompt (170) for a generative artificial intelligence model configured for natural language processing (150), based on the control logic code (160);
performing a similarity search by means of a database (122) and based on the simulation generation prompt (170), wherein the database (122) comprises embeddings of a plurality of elements of a project context (126) of the automatic industrial process;
generating an augmented simulation generation prompt (180), wherein the simulation generation prompt (170) is augmented based on results of the similarity search;
providing the augmented simulation generation prompt (180) to the generative artificial intelligence model (150); and
generating the simulation code (190) for testing the control logic code (160) by means of the generative artificial intelligence model (150), based on the augmented simulation generation prompt (190).

## Description

### Background

Automating production plants in, e.g., chemical industries or power production requires implementing control logic to be executed by means of Programmable Logic Controllers (PLC) or Distributed Control Systems (DCS). Creation of control logic code for controlling an automated industrial process can require processing of complex requirements, which are specified, e.g. in form of P&IDs, I/O tables or control narratives. Prior to executing the control logic code, it can be required to test the control logic code based on realistic simulation environments, to make sure the control logic code is functionally correct and/or safe. Creating a simulation environment can be a complex process and can require substantial domain expertise, can be expensive and can require a specialist.

### Detailed description of the invention

Control logic code can be expressed or formulated in different notations, e.g., as program source code, function block diagrams, or sequential function charts.

The control logic can control actuator operations, e.g., opening a valve, stopping a pump, turning on a heat exchanger, as output, based on received sensors readings from production equipment as input. The control logic code need to be thoroughly tested, particularly to avoid harm to equipment and human beings. Testing control logic prior to usage in production can require a simulation environment, to provide sensor data required for executing and testing the control logic code and to emulated or simulated input-signals for controlled actuators, particularly for ensuring correct functionality of the control logic code.

Accordingly, testing the control logic code can be time-consuming and can require adapting specific requirements of the automated industrial process. Any changes of the automated industrial process can require an elaborate reconfiguration of a simulation environment. This is particularly complex if chemical reactions or flow models related to the industrial process are involved.

Process simulators for automated systems can enable testing control logic code and for training human operators. Designing process simulators can be a complex task and can require deep domain knowledge, e.g., about chemical processes or physical conditions of the industrial process. Creating simulation libraries for chemical processes can require sophisticated procedures for emulating almost realistic chemical reactions or for emulating behavior of equipment and components involved. Such simulation libraries are designed and can be created by specialists rather than automation providers and can be configured specific for simulating a specific industrial process.

Recently, generative Al in form of large language models (LLM) made significant technological advances and became widely available for end users. Tests have shown that generative Al can generate control logic source code, e.g., in programming languages defined in IEC 61131-3, and by queries to the generative Al based on requirements formulated in natural language. Using P&IDs, I/O list, and control narratives as input for the generative Al can be a potential solution to generate simulation code for testing control logic code.

Accordingly, the present invention is directed to a method for generating a simulation code to test a control logic code, a method for testing control logic code, a controller for controlling an automated industrial process, a device for generating a simulation code, and a use of a generative artificial intelligence model for generating simulation code, as described in the independent claims.

Advantageous modifications of the invention are stated in the dependent claims. All combinations of at least two of the features disclosed in the description, the claims or the figures fall within the scope of the invention. In order to avoid repetition, features disclosed in accordance with the method shall also apply and be claimable in accordance with mentioned systems or devices.

In this entire description of the invention, the sequence of procedural steps is presented in such a way that the process is easily comprehensible. However, the skilled person will recognize that many of the process steps can also be executed in a different order and lead to the same or a corresponding result. In this sense, the sequence of the process steps can be changed accordingly. Some features are provided with counting words to improve readability or to make the assignment more clear, but this does not imply the presence of certain features.

To achieve these and other advantages and in accordance with the purpose of the invention, as embodied and broadly described herein, there is provided a method for generating a simulation code for testing a control logic code, wherein the control logic code is configured for controlling an automated industrial process, the method comprising the following steps. In a step, the control logic code is provided for execution of the method, wherein the control logic code comprises identifiers, which are related to a plurality of components of the automated industrial process. In a further step, a simulation generation prompt for a generative artificial intelligence model configured for natural language processing is generated, based on the control logic code. In a further step, a similarity search is performed by means of a database and based on the simulation generation prompt, wherein the database comprises embeddings of a plurality of elements of a project context of the automatic industrial process. In a further step, an augmented simulation generation prompt is generated, wherein the simulation generation prompt is augmented based on results of the similarity search. In a further step, the augmented simulation generation prompt is provided to the generative artificial intelligence model. In a further step, the simulation code for testing the automated industrial process is generated by means of the generative artificial intelligence model, based on the augmented simulation generation prompt.

The elements of the project context can include requirement artefacts and/or a plurality of specifications of an appliance structure of the automated industrial process, wherein the appliance structure comprises a plurality of components and/or subcomponents.

Additionally or alternatively, the elements of the project context and/or the requirement artefacts can include a plurality of functional requirements of each component of the automated industrial process.

Accordingly, the control logic code can include identifiers of the elements of the project context and/or of the requirement artefacts and/or of the plurality of specifications of an appliance structure of the automated industrial process, and/or of functional requirements of each component of the automated industrial process.

Elements of a project context can include a topology of the automated industrial process and/or l/or lists.

A topology of the automated industrial process, that means topological information about the production process and instrumentation (P&I) requirements for automation, being a part of the project context, as an example of a requirement artefact, can be provided by P&I diagrams, which are typically described by a verbose notation, as e.g., XML as defined by the DEXPI P&ID specification. P&I diagrams can be provided and received in structured file formats, e.g. according to the DEXPI or the ISO15926 standard.

Types of input and output signals for automation can be specified using input/output (I/O) lists, as an example of a requirement artefact, which are often large spreadsheets, where inputs and outputs are specified with various attributes, e.g., analog/digital, ranges, etc. I/O descriptions can be provided in terms of rows, where following columns are included, e.g., I/O number, Tag number, Loop number, P&ID number, location, I/O type, calibration limits, set points, engineering units, value range, etc. Since an I/O table already contains a set of condensed information, a further reduction can be achieved by omitting redundant parts of the I/O list, e.g., a running number column.

A control concept or automation concept can be specified using a so-called control narrative, a plain text document written in a technology/vendor agnostic way, describing the automation requirement in prose.

Based on these requirement artifacts or documents, the automation of the industrial process can be defined and can be specified as described by IEC 61131-3 or IEC 61499.

The database can comprise, a vector database being a specialized database designed to efficiently store, search, and manage high-dimensional vector data, often used in applications like machine learning, image and voice recognition, and similarity searches. These databases enable rapid nearest neighbor search operations, allowing users to identify vectors quickly in the database that are most like a given input vector. The vector databases can be a FAISS database, which is developed by Facebook Al or an Annoy database, which is developed by Spotify or a Pinecone database.

Embeddings can be a concept in the world of machine learning and artificial intelligence, predominantly in the realm of deep learning. It allows for the conversion of categorical data, such as words or items, into vectors of continuous numbers. Embeddings can capture underlying semantics and relationships between different categories, which can improve the performance of machine learning models. Embeddings can be learned from large datasets and particularly they can be available for use in other tasks without the need for training from scratch.

Embeddings of a requirement artefacts and/or a prompt can be generated by means of a generative artificial intelligence model, e.g., an LLM model, to create an embedding representation of the input text, e.g. by means of a vector of numbers, wherein the requirement artefacts and/or chunks of the requirement artefacts can be pre-processed by a transformation. Using other words, embeddings can be representations of values or objects like text, images, and audio that are designed to be used by machine learning models and semantic search algorithms.

An embedding encoder can be configured to generate embeddings from documents and specifications into numeric vector representations, known as embeddings, for storing the embeddings in a vector database for easy querying. Examples are OpenAl embeddings or LLaMA embeddings or custom domain-specific embeddings.

For example, from the project context a set of PDF or Word files can be subject to the encoding. For the simulation library, the embedding encoder can process the specifications of the simulation elements, e.g., inputs, outputs, SIM-method signatures simulations, processing steps, or even the source code of the simulation elements if available.

The similarity search can be performed by comparing embeddings stored in the vector database, with an embedding of the simulation generation prompt related to the plurality of components and/or subcomponents for controlling the industrial process. The matching chunks can be retrieved from a database and/or the vector database, and be augmented to the simulation generation prompt. The similarity search based on embeddings and augmenting the simulation generation prompt can be performed according to an embedding retrieval method.

The similarity search can be based on the simulation generation prompt including the control logic code featuring the identifiers, to search, by means of the identifiers, for similar pairs of embeddings of the plurality of elements of the project context and the control logic code.

The control logic code can be a computer program comprising instructions, which, when the computer program is executed by a computer and/or a programmable logic controller (PLC), cause the computer and/or the PLC to execute the instructions. The control logic code can be coded based on a control code programming language, as e.g., IEC 61131-3, IEC 61499, and/or based on Modelica, or MATLAB/Simulink and/or based on a general-purpose programming language, as e.g., Python, or C#.

The automated industrial process can be a process, which is controlled by means of intelligent technology to replace manual, mundane, repetitive tasks with highly efficient and/or automated workflows. This can overcome tasks for operators to monitor performance values and quality of output physically and manually for determining the best settings to run production equipment and/or production components, particularly including subcomponents. The automated industrial process can be based on a usage of sensors, automatic control devices, computer technology and software engineering to simplify and manage these tasks. Data can be collected through thousands of sensors at different locations throughout the facility. Related information can be stored and analyzed using a computer device. A plurality of processes and/or machines can be monitored and controlled in a control room visualized by a large screen.

The generative artificial intelligence model, which is configured for natural language processing, can be a large language model (LLM), e.g., LLAMA, GPT, or Bard.

Such a large language model can be a type of language model, which can be based on artificial neural network and trained, e.g., instruction-tuned, on a vast amount of general-purpose knowledge.

The generative artificial intelligence model can be configured to output answers responding to input queries. The answers provided can include textual explanations or formal computer-processable code, e.g., in a notation used by a programmable logic controller. The generative artificial intelligence model can be used, e.g., to answer user queries. LLMs can acquire these abilities by learning statistical relationships from text documents during a computationally intensive self-supervised and semi-supervised training process. LLMs are artificial neural networks, the largest and most capable of which are built with a transformer-based architecture. Some recent implementations are based on other architectures, such as recurrent neural network variants and Mamba (a state space model).

The generative artificial intelligence model can be additionally or alternatively a customtrained model configured specifically for simulations in industrial automation or a fine-tuned general purpose LLM.

The LLM can be fine-tuned based on available control logic code and/or simulation code or generated from scratch (self-supervised way) using available simulation code snippets. The fine-tuning can be performed by available control logic code, which is linked to specifications of applicant's structures, comprising a plurality of components, and/or a plurality of functional requirements of each component of the automated industrial process.

Some notable LLMs are OpenAl's GPT series of models (e.g., GPT-3.5 and GPT-4, used in ChatGPT and Microsoft Copilot), Google's PaLM and Gemini (used in Bard), Meta's LLaMA family of open-source models, and Anthropic's Claude models.

Generating the simulation generation prompt can be based on templates for prompt generation, wherein the templates are associated to category of tasks for control logic code generation. Based on a tasks statement the simulation generation prompt can be generated by selected templates of prompts, which are related to the task.

The simulation generation prompt can be augmented by elements of the project context and/or chunks of the plurality of specifications of an appliance structure of the automated industrial process, and/or the plurality of functional requirements of each component of the automated industrial process. The chunks of the plurality of specifications and/or functional requirements can be selected by a similarity search, which is based on embeddings of the plurality of specifications and/or functional requirements and embeddings of the simulation generation prompt.

A database and/or a vector database can be used for storing embeddings of the plurality of, particularly transformed, specifications of an appliance structure of the automated industrial process, and/or embeddings of the plurality of, particularly transformed, functional requirements of each component of the automated industrial process. The embeddings of the plurality of specifications and/or functional requirements can be stored by means of the vector database for performing the similarity search based on the embeddings.

The simulation code can be specified in a simulation modeling notation, e.g., Modelica, or MATLAB/Simulink, or a general-purpose programming language, e.g., Python, or C#, or a control code programming language, e.g., IEC 61131-3, IEC 61499.

The method for generating the simulation code can include steps to supervise or verify generated simulation code and prompt the generated artificial intelligence model iteratively in case of errors in the simulation code. This iteration can continue until a simulation engine, performing the verification of the generated simulation code, can successfully run the simulation or a timeout occurs. This way there will be a failsafe mechanism without a user involvement

Using other words, the method for generating the simulation code can include a simulation generator that can generate the simulation code using only natural language inputs from an input and/or an operator. The simulation generator can use generative artificial intelligence (Al) in form of a large language model to generate simulation code that can be executed by a simulation engine to provide input values to the control logic to be tested. After a simulation run, which can be performed by the simulation engine, the control logic code is either deemed correct or can be further refined and extended to address the requirements.

Advantageously, the methodology of the method for generating the simulation can save a significant amount of effort for generating simulation code. Due to the natural language interface and the use of a large language model, a realistic simulation environment can be generated even with limited specialized expertise of an operator. Generating an industrial automation process simulation model, based on the generated simulation code, using generative Al can be flexible in respect to adaptations of the automated industrial process and can be a powerful tool for testing control logic code.

By means of retrieval augmented generation of the simulation code, based on embeddings, project specifics and available simulation blocks can be taken into account.

The method for generating the simulation code can be integrated into a control programming environment, so that it can be conveniently accessed by operators for testing control logic.

The method for generating the simulation code can improve the generation of control logic code and can reduce a probability of plant accidents or suboptimal industrial process automation.

The method for generating the simulation code can accelerate engineering of control logic code and/or simulation code, since problems in the control logic code can be addressed early in the process of engineering, even if the automated industrial process has not yet been installed.

The method for generating the simulation code can save cost for manually creating a simulation of the automated industrial process, enabling the use of simulations of control logic code for smaller production plants.

Because of the possibility of incorporating domain knowledge, e.g. by process-specific documentation and/or historical data to the method, the method for generating the simulation code can improve the simulation of the control logic code.

According to an aspect, the augmented simulation generation prompt, as provided to the first generative artificial intelligence model, can be extended by amending a guidance, how to interpret I/O signal names, particularly based on tag name definitions of IEC 62424, for example: "if signal name starts with P" it means that it is connected to a "pressure" measurement.

According to an aspect, the control logic code can comprise identifiers, which are related to a plurality of specifications of an appliance structure of the automated industrial process, wherein the appliance structure comprises a plurality of components and/or subcomponents. Alternatively or additionally, the control logic code comprises identifiers, which are related to a plurality of functional requirements of each component of the automated industrial process. The similarity search can be performed by means of a vector database and is based on the simulation generation prompt, wherein the database comprises embeddings of the plurality of specifications of an appliance structure and/or embeddings of the plurality of functional requirements of each component of the automated industrial process, wherein the augmented simulation generation prompt is augmented based on results of the similarity search.

The plurality of specifications of an appliance structure of the automated industrial process, which can comprise a plurality of components and/or subcomponents, and/or the plurality of functional requirements of each component of the automated industrial process, can be based on a project context. The project context can comprise documents and specifications about a particular automation-engineering project and/or an automated industrial process, particularly to describe the project context. For example, such documents can be requirements specifications, control narratives, contracts, design specifications, domain-specific textbooks, engineering handbooks, and/or other documents that can help to understand details about the intended industrial production process. For example, for an automation-engineering project of a chemical plant producing a specific kind of chemical substance, the documents of the project context can have detailed information about the ingredients used, the dimensions of the equipment, and the intended procedures, as e.g., mixing, boiling, reacting, etc. This can also include piping-and-instrumentation diagrams (P&ID), process flow diagrams (PFD), and/or system control diagrams (SCD), for example. If the automated industrial process has already been operating, the project context can also include historical data, such as time series of measurements and/or alarms and/or process events.

To tailor the simulation for a specific project, the method for generating the simulation code can comprise retrieval-augmented generation to prompt a large language model that has been trained on vast amounts of knowledge. The large language model can directly output generated simulation code that can be fed to a simulation engine to realize the desired simulation environment. By means of a simulation environment, an operator can test specific control logic code using simulated and/or historical sensor values and equipment behavior.

According to an aspect, the method can include the following steps.

In a step, a simulation task statement for generating a simulation code for the generative artificial intelligence model is provided. In another step, the augmented simulation generation prompt for the generative artificial intelligence model is generated, based on the simulation task statement for generating a simulation code and the control logic code.

According to an aspect, the method can include the following steps.

In a step, a plurality of blocks of logic code for process or component simulation for simulating the process of the automated industrial process is provided , wherein the process simulation codes comprises identifiers, which are related to a plurality of components performing the process of the automated industrial process. In another step, embeddings of the plurality of blocks of logic code for process or component simulation are generated. In another step, the embeddings of the plurality of the blocks of logic code for process or component simulation in the vector database are stored. In another step, the similarity search by means of the vector database based on the simulation generation prompt is performed, based on the embeddings of the plurality of specifications of the appliance structure, and/or based on the embeddings of the plurality of functional requirements of each component of the automated industrial process, and/or based on embeddings of the plurality of the blocks of logic code for process or component simulation.

According to an aspect, the blocks of logic code for process or component simulation can comprise: Code in respect to mechanical-; and/or electrical-; and/or control-behavior, and/or control-characteristics of a of component of the plurality of components of the automated industrial process, and/or code in respect to simulation of a chemical reactions, which are related to the automated industrial process. Particularly, the code in respect to the simulation of the chemical reactions can be related to emulating close-to-reality chemical reactions, and/or close-to-reality behavior of components of the automated industrial process, for testing the control logic code based on the generated simulation code.

According to an aspect, the method can include the following steps.

In a step, a simulation code syntax is provided, which is feasible for running the generated simulation code. In another step, the generated simulation code, which is generated by the generators artificial intelligence model, is compared with the simulation code syntax, to verify the simulation code.

The simulation generator can while generating the simulation environment, additionally use a knowledge-representation component, which provides "guardrails", e.g., certain typical simulation base setups, which must be followed for consistency reasons, or "lookup" table functionalities, e.g., lookup tables about chemical engineering domain, how certain plant components must be wired to test the control logic accordingly.

For this, a domain-specific and simulation-scoped knowledge graph can be constructed before applying the approach. This is can be a manual or a semi-automated task and can result in a graph that can be queried using typical graph queries. The graph can be independent of a particular automation project and rather cover fundamental knowledge of simulation in the industrial automation domain. For integrating such a graph into the simulation generation methods, different techniques, such as text-to-graph queries or retrieval-augmented generation can be applied. This allows comparing LLM outputs with violations towards the knowledge stored in the graph and thus reducing potential hallucinations. For example, the knowledge graph could stipulate how specific simulation blocks can be combined and thus prevent the LLM from generating erroneous simulation block combinations.

According to an aspect, the method can include the following steps.

In a step, a look up table is provided, which represents a plurality of functionalities the simulation code is required to fulfil for testing the control logic code. In another step, the generated simulation code, which is generated by the generative artificial intelligence model, is compared with a plurality of functionality requirements for testing the control logic code, as provided by the lookup table, to verify the generated simulation code.

According to an aspect, the generative artificial intelligence model is based on a general generative artificial intelligence model, which is trained by a plurality of pairs of blocks of preassembled control code and associated preassembled simulation logic code, particularly for fine-tuning the generative artificial intelligence model for specific tasks of generating simulation code.

According to an aspect, the method can include the following steps.

In a step, the augmented simulation generation prompt is partitioned into a plurality of parts of the augmented simulation generation prompt, particularly to comply with a token limit that is required for an input of the generative artificial intelligence model. In another step, a plurality of parts of the simulation code is generated, based on the plurality of the parts of the augmented simulation generation prompt. In another step, the simulation code is assembled, based on the plurality of the parts of the simulation code.

According to an aspect, the method can include the following steps.

In a step, the augmented simulation generation prompt is amended with a rule to prioritize the plurality of specifications of an appliance structure of the automated industrial process, particularly to minimize or avoid a risk of overfitting the simulation code to the control logic code. Alternatively or additionally, the augmented simulation generation prompt is amended with the plurality of functional requirements of each component of the automated industrial process, higher than the control logic code for generation of the simulation code, particularly to minimize or avoid a risk of overfitting the simulation code to the control logic code.

According to an aspect, the method can include the following steps.

In a step, a series of historical control data is provided, including a plurality of pairs of sensor data related to actuator operation data associated to at least one component of the automated industrial process. In another step, embeddings of the plurality of pairs of sensor data assigned to actuator operation data related to at least one component of the automated industrial process are generated. In another step, the embeddings of the plurality of pairs of sensor data and related actuator operation data related to at least one component of the automated industrial process are stored by means of the vector database, for augmenting the simulation generation prompt based on the results of the similarity search.

According to an aspect, the method for generating a simulation code can include the step of editing and/or amending and/or changing the following tasks, wherein the editing and/or amending and/or changing the task can be performed by an operator by means of an interface,
- providing the control logic code; and/or
- generating a simulation generation prompt for a generative artificial intelligence model configured for natural language processing; and/or
- generating an augmented simulation generation prompt; and/or
- generating the simulation code; and/or
- providing a simulation task statement for generating a simulation code for the generative artificial intelligence model; and/or
- providing a plurality of blocks of blocks of logic code for process or component simulation for simulating the process of the automated industrial process; and/or
- providing a simulation code syntax; and/or
- providing a look up table; and/or
- partitioning of the augmented simulation generation prompt into a plurality of parts of the augmented simulation generation prompt; and/or
- providing a series of historical control data.

By editing and/or amending and/or changing a plurality of steps of the method for generating the simulation code, an automation engineer can supervise the generation of the simulation code but is relieved from manual coding control logic.

A device for generating a simulation code to test a control logic code is proposed, wherein the control logic code is configured for controlling an automated industrial process, comprising a first interface, a database, a data processing apparatus and a second interface. The first interface is configured for receiving the control logic code. The database is configured to store embeddings of a plurality of elements of a project context of the automatic industrial process. The data processing apparatus is signally coupled to the first interface and/or the database. The second interface is signally coupled to the data processing apparatus, wherein the second interface is capable to be coupled to a generative artificial intelligence model configured for natural language processing. In addition, the device for generating a simulation code comprises means and/or the device for generating a simulation code is configured, to carry out one of the methods for generating a simulation code as described above.

A method for testing control logic code is proposed, including the following steps.

In a step, the control logic code is provided. In another step, a simulation code is generated according to any one of the methods as described above. In another step, the generated simulation code is executed, by means of a simulation engine. In another step, the control logic code is executed, by means of a runtime system, which is coupled to the simulation engine to test the control logic code.

A process-controller for controlling an automated industrial process is proposed, comprising a programmable logic controller, or a distributed control system of the automated industrial process, a storage memory and a controller-interface and a process-controller.

The storage memory is coupled to the programmable logic controller, and/or the storage memory is coupled to the distributed control system, wherein the storage memory is configured to store a control logic code for the programmable logic controller.

The controller-interface is signally coupled to the programmable logic controller. Additionally, the controller-interface is configured to be signally coupled to a plurality of components and/or subcomponents of an automated industrial process system. The process-controller is configured to control the automatic industrial process, based the control logic code, which is tested by any one of the methods as described above.

A computer-implemented method for generating a simulation code to test a control logic code is proposed, according to any one of the methods as described above.

A use of a generative artificial intelligence model configured for natural language processing is proposed for generating simulation code for testing control logic code according to any one of the methods for generating a simulation code as described above. Alternatively or additionally, a use of the generators artificial intelligence model configured for natural language processing is proposed for testing the control logic code according to the method for testing a control logic as described above.

### Brief description of the drawings

The accompanying drawing, which is included to provide a further understanding of the invention and is incorporated in and constitute a part of this application, illustrate embodiments of the invention and together with the description serve to explain the principle of the invention. The drawings are displayed by:

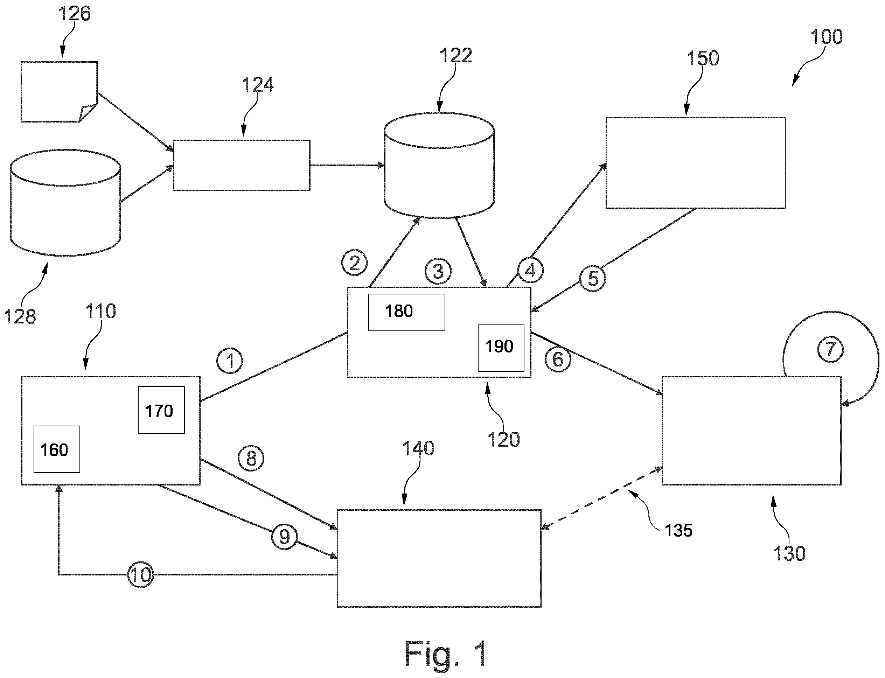

FIG. 1 a data flow diagram of a method to generating simulation code.

Figure 1 sketches schematically a data flow 100 of a method for generating a simulation code 190 for testing a control logic code 160, wherein the control logic code 160 is configured for controlling an automated industrial process. The data flow 100 is depicted within an architecture of a simulation-environment and/or a test-environment including a control programming environment 110, a simulation generator 120, a simulation engine 130, a vector database 122, a project context database 126, an embeddings encoder 124, a simulation library 128, a control runtime system 140, and a generative artificial intelligence model configured for natural language processing (large language model) 150. Additionally, figure 1 sketches schematically a data flow of a method to test the control logic code 160 using the simulation code 190.

The control programming environment 110 can be a PLC or DCS integrated development environment, i.e., a software application running on a workstation or laptop, which supports writing control logic, e.g., in IEC 61131-3. It can provide, for example, control logic editors, compilers, control logic libraries, and testing tools. The control programming environment 110 can allow control engineers to deploy an engineered control logic code to a controller, i.e., an embedded device automation controller or an industry PC, where the control logic code 160 can be executed.

A plug-in of the control programming environment 110 can provide a chat interface to the simulation generator 120 and/or the generators artificial intelligence model 150, so that it can be seamlessly accessed when designing control logic code 160.

Using other words, the simulation generator 120 can be a software program that takes a natural language prompt as input and is configured to generate simulation code 190. The prompt can comprise descriptions of the desired control logic, for instance as a task statement, and the control logic code 160 for the generation of simulation code 190. The simulation generator 120 can be configured to use the generative artificial intelligence model 150 to generate the simulation code 190, particularly iteratively. While the generative artificial intelligence model 150 can include information about, e.g., chemical processes or power production processes, which support the generation of the simulation code 190. The simulation generator can be provided with additional information regarding the project context. Therefore, the simulation generator 120 can be configured to augment the simulation generation prompt 170 by performing a similarity search on a vector database 122 populated with embeddings of elements of the simulation library 128 and elements of the project context database 126, wherein the augmentation can be termed: "Retrieval Augmented Generation". The augmented simulation generation prompt 180 including project-specific context can be provided to the generative artificial intelligence model 150 to generate the simulation code according to a specific notation, as for instance modellica, for a specific simulation engine, as e.g. a modellica engine.

The project context can include documents and specifications about a particular automated industrial process. For example, such documents can be requirements specifications, control narratives, contracts, design specifications, domain-specific textbooks, engineering handbooks, and other documents that can help to understand details about the intended production process.

For example, for an automated industrial process of a chemical plant, producing a specific kind of chemical substance, the documents can include detailed information about the ingredients used, the dimensions of the equipment, and the intended procedures, e.g., mixing, boiling, reacting, etc. This can also include piping-and-instrumentation diagrams (P&ID), process flow diagrams (PFD), or system control diagrams (SCD), for example. When the process has already been operating, the context can also include historical data, such as time series measurements and alarms and events.

The simulation library 128 can include several pre-specified simulation elements including blocks of logic code for process or component simulation, e.g., to simulate the behavior of a pump or to simulate the properties of a chemical reaction. The simulation elements can support a low-fidelity simulation, e.g., by neglecting details of chemical reactions, or high-fidelity simulation, which provides a detailed physical simulation and/are model based simulation of real process system for specific substances and types of equipment and/or components of the automated industrial process. Examples for simulation libraries are the Modelica Heat Exchanger or Thermal Power Libraries, or MathWorks Simscape Block Libraries.

The vector database 122 can be specialized database designed to efficiently store, search, and manage high-dimensional vector data, often used in applications like machine learning, image and voice recognition, and similarity searches. These databases enable rapid nearest neighbor search operations, allowing to quickly identifying vectors in the database that are most like a given input vector. Three example vector databases are FAISS (developed by Facebook Al), Annoy (developed by Spotify), and Pinecone.

The simulation engine 130 can serve as runtime system for the generated simulation code 190. It can interpret or compile and execute the simulation code 190 provided as input. The simulation engine 130 can continuously execute the simulation code 190 and produces output signals, for mimicking sensor readings from the production process, based on input signals, e.g., other sensor readings, control logic output, operator set points, etc.

To continuously iterative exchange the signals with a control runtime system 140 executing the control logic code 160 to be tested, the simulation engine 130 can include a communication protocol, for example as implemented by an OPC UA (Unified Architecture) server. The generated signals can be published over a network by the OPC UA server, so that they can be read by the control runtime system 140, which can include an OPC UA client, and which is coupled to the simulation engine 130.

The control runtime system 140 can be an execution engine for the control logic code 160 to test, e.g., IEC 61131-3 or IEC 61499 code. It can be configured to execute application tasks specified in the control logic code 160, e.g., every 250 ms, and supplies the current input readings received from an OPC UA client via the network to execute the control logic code 160. These input readings are the simulated sensor values produced by the simulation engine 130. By executing the algorithms encoded in the control logic code 160, e.g. a PID controller, the control runtime system 140 can compute output signals, e.g., the set point for a control valve or the activation of a pump, and can transmit them via OPC UA to the OPC UA server of the simulation engine 130, which thus has new inputs to execute the simulation logic 190.

The project context database 126 can be configured to store a plurality of specifications of an appliance structure of the automated industrial process, wherein the appliance structure comprises a plurality of components and/or subcomponents. Alternatively or additionally, the project context database 126 comprises a plurality of functional requirements of each component of the automated industrial process. Embeddings of elements of the project context database, including the plurality of specifications of the appliance structure of the automated industrial process, and/or a plurality of functional requirements of each component of the automated industrial process, can be generated by means of an embedding encoder 124 and are stored by means of the vector database 122.

The simulation library database 128 can be configured to store a plurality of blocks of logic code for process or component simulation, which are configured to emulate and/or simulate processes or components of the automated industrial process. The plurality of blocks of logic code for process or component simulation are related to the automated industrial process and can comprise identifiers, which are related to the plurality of processes and/or components performing the process of the automated industrial process. The plurality of blocks of logic code for process or component simulation includes code and/or methodology related to simulation of a chemical reactions and/or components of the automated industrial process.

If a real automated industrial process is running and particularly changes or extensions to the control logic code shall be tested, the simulation library database 128 can comprise pre-recorded sensor data from the real production process, which model the processes of the industrial process more precise than the simulation blocks from the simulation library 128, since the pre-recorded sensor data can account for actual dimensions and conditions on site, which may not fully match with the conditions assumed in the design phase of the automated industrial process.

The simulation library database 128 can additionally comprise previously recorded or assumed operator actions, which are related to specific industrial processes to enhance the modelling of the emulated processes.

Embeddings of the plurality of blocks of logic code for process or component simulation and/or other elements of the simulation library database 128 can be generated by means of an embedding encoder 124 and stored by means of the vector database 122.

In a step 1 of the method, the control logic code 160 and a simulation task statement for generating the simulation code 190 is provided to execute the method, particularly by means of the control programming environment 110, preferably using a plugin for coupling with the simulation generator 120.

The control logic code 160 comprises identifiers, which are related to a plurality of components of the automated industrial process. The identifiers can be related to a specific project context of the automated industrial process, which is stored by means of the project context database 126.

The identifiers can be related to the specific project context, wherein the project context comprises a plurality of specifications of an appliance structure of the automated industrial process, and wherein the appliance structure comprises a plurality of components and/or subcomponents. Alternatively or additionally, the control logic code 160 comprises identifiers, which are related to the project context, wherein the project context comprises a plurality of functional requirements of each component of the automated industrial process.

The control logic code 160 to be tested can be hand-written by a control engineer but can alternatively or additionally be generated by a another generative artificial intelligence model configured for natural language processing as for instance a large language model based on natural language requirements.

Further in step 1, a simulation generation prompt 170 for the generative artificial intelligence model 150 is generated, based on the control logic code 160 and based on the simulation task statement, particularly for closer defining the generating of the simulation code 190, by means of the control programming environment 110, particularly to requests the generation of simulation logic code 190 for testing a given control logic code 160, via a natural language simulation generation prompt 170. The simulation generation prompt 170 can additionally include textual information that provides additional information to the simulation generator 120, e.g., that a substance in a tank, whose level shall be controlled, by means of the control logic code 160, is crude oil, alternatively this information can be provided by the stored project context 126. The simulation task statement can include a desired notation for the generate simulation code.

An example of a simulation generation prompt 170 is given below:
Write Modellica code to simulate the chemical reactions in an ammonium nitrates reactor.
Provide no explanations, just the code.
The Modellica code shall be used to test the following control logic: 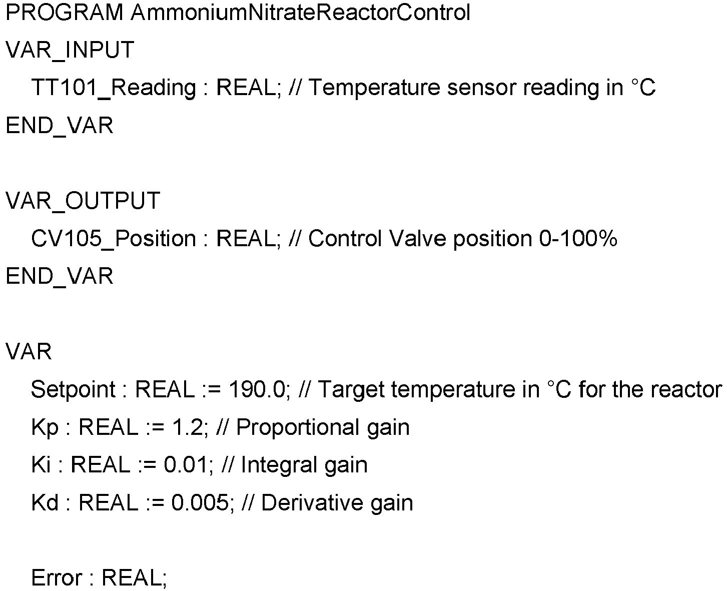 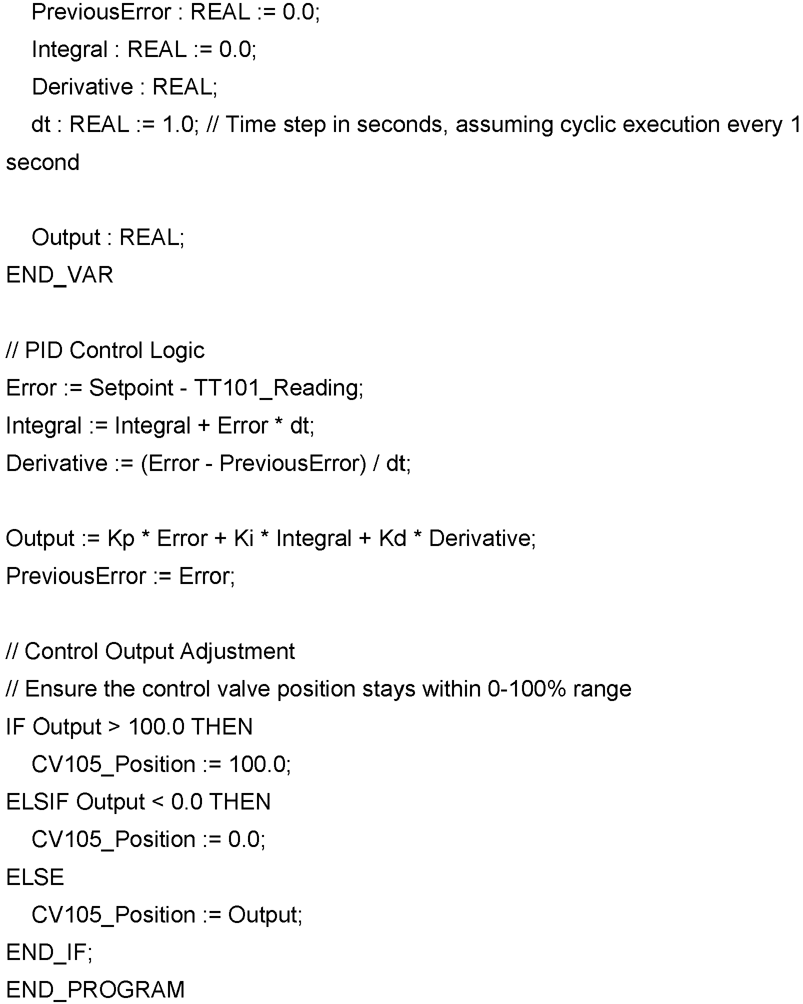
End of the example.

The vector database 122 can be pre-populated to comprise embeddings of the plurality of elements of a project context of the automated industrial process, including embeddings of the plurality of specifications of the appliance structure of the automated industrial process, wherein the appliance structure comprises a plurality of components and/or subcomponents. Alternatively or additionally, the vector database 122 can be pre-populated to comprise a plurality of embeddings of the functional requirements of each component of the automated industrial process.

In a further step 2, a similarity search is performed by means of the vector database 122 initiated by the simulation generator 120 and is based on the simulation generation prompt 170 including the control logic code featuring the identifiers, to search, by means of the identifiers, for similar pairs of embeddings of the plurality of elements of the project context, which are related to the simulation generation prompt including the control logic code.

The similarity search can search for similar pairs of similar embeddings, particularly including the simulation generation prompt 170, from the vector database 122 and provide information and/or documents and/or code, which is related to the respective pairs of similar embeddings. A similiarity search can provide a scoring function for the search results, whose output can be used to run additional searches in case the score is too low. In this case, the simulation generator can perform multiple similarity searchers and select the search results with the highest score.

In a further step 3, an augmented simulation generation prompt 180 is generated, wherein the simulation generation prompt 170 is augmented based on results and/or output and/or documents of the similarity search by means of the simulation generator 120.

In a further step 4, the augmented simulation generation prompt 180 is provided to the generative artificial intelligence model 150. The generative artificial intelligence model 150 can generate the simulation code 190 based on the augmented simulation generation prompt 180 and particularly based on a plurality of training data, particularly in the desired notation. The simulation code can reference to fitting blocks of logic code for process or component simulation from the simulation library database 128, so that blocks of logic code for process or component simulation in these blocks can be reused. This can enhance reliability and trust in the generated simulation code. Alternatively or additionally, the generative artificial intelligence model can generate at least parts of the lowlevel simulation logic, based on the requirements provided by the augmented simulation generation prompt provided to the generative artificial intelligence model. This may involve basic mathematical calculations for simulating specific sensor values.

In a further step 5, the simulation code 190 for testing the control logic code 160 is generated by means of the generative artificial intelligence model 150, based on the augmented simulation generation prompt 180.

The generated simulation code 190 can provide a simulation model, which performs a low-fidelity, medium-fidelity, and even high-fidelity simulation, based on a content of the simulation library database 128 and the publicly available domain knowledge accessible by the generative artificial intelligence model.

An example of a simulation code generated by a large language model is given below:

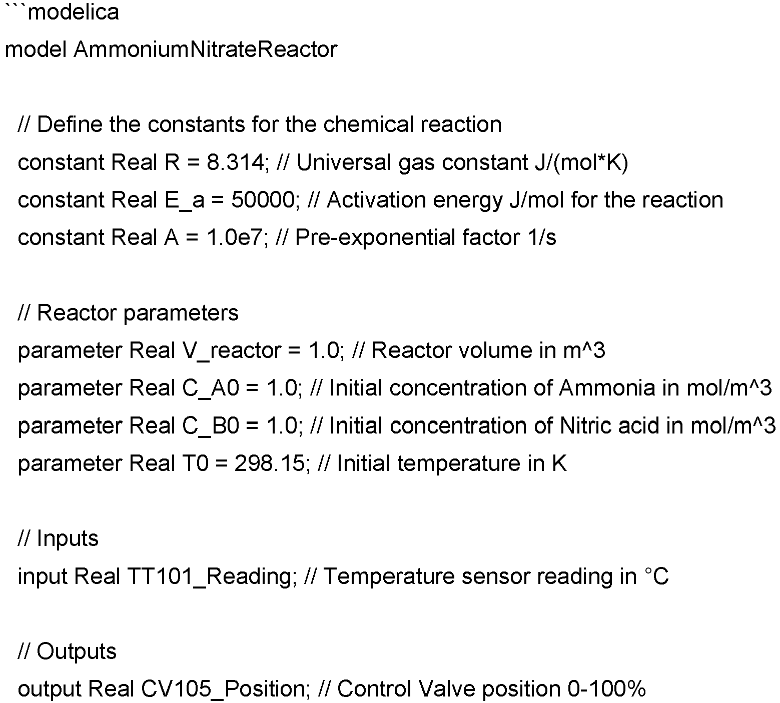

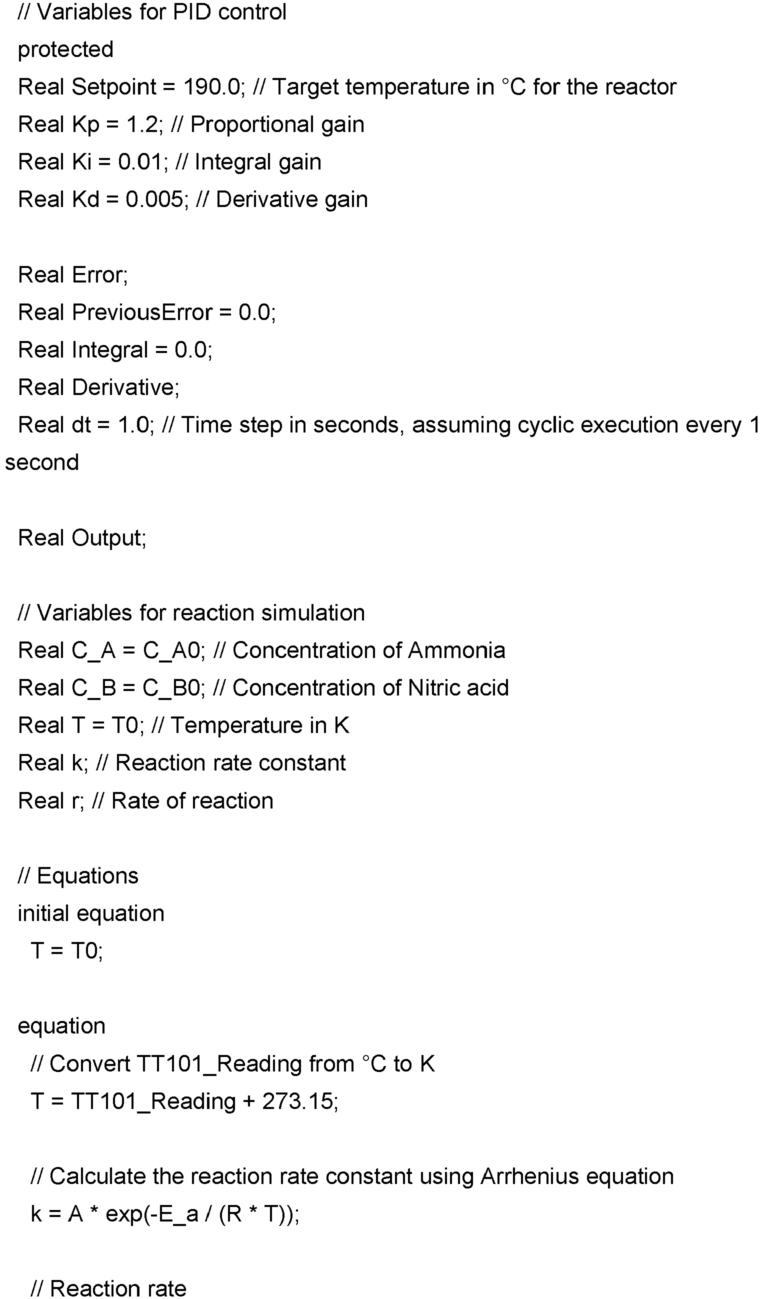

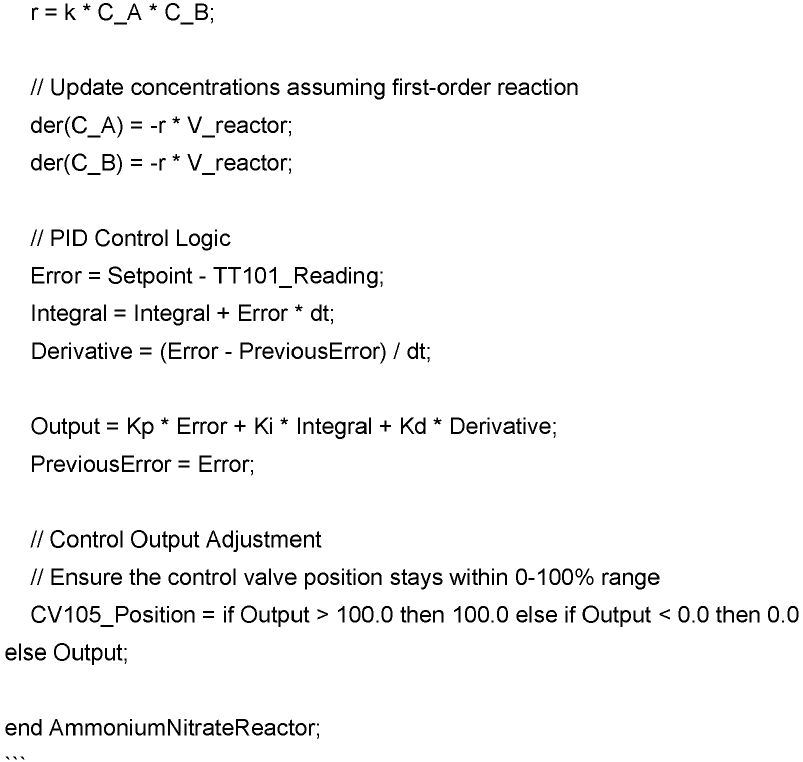

End of the example of the simulation code.

Steps 4 and 5 can be iteratively performed in case the augmented simulation generation prompt 180 exceeds the token limit of the generative artificial intelligence model 150. In this case, the simulation generator can be configured to provide the augmented simulation generation prompt 180 in parts to the generators artificial intelligence model 150, to generate parts of the simulation code 190 iteratively in a batch fashion.

In a further step, the simulation code 190 can be provided to the simulation generator 130 for execution. This can be done via REST calls or a plain text file transfer.

Alternatively or additionally, the simulation generator 130 can be configured to compare the generated simulation code 190, with a provided and/or internal simulation code syntax, to verify the simulation code 190. The simulation generator 120 can be configured to interact with the simulation engine 130 to execute the simulation code 190 and decide whether it is syntactically correct.

The method for generating the simulation code 190 can include, that, depending on the result of the comparison, the generated simulation code 190 is provided by the simulation generator 120, based on a revised augmented simulation generation prompt.

An internal quality scoring, performed by comparing the generated simulation code 190 with a simulation code syntax can be optionally based on querying a knowledge representation component, e.g., based on ontology, that guardrails the simulation functionality, e.g. by means of Knowledge-graphen.

In a further step 7, the simulation engine 130 can be configured to instantiates the provided generated simulation code 190 and starting the simulation process, which can run continuously altering simulation code output signals based on recorded and/or generated input signals. The simulation can start with default input values, which will later be overwritten by the control runtime.

In a further step 8, with the simulation engine 130 started, an operator can deploy the control logic code 160 to be tested via the control programming environment 110 to a control runtime system 140, i.e., a soft controller running on PC hardware, and start its execution. The control runtime system 140 can be configured to receive input signals from the simulation engine 130 via a communication protocol 135, such as OPC UA, or in general, any chosen communication protocol, to produce output signals for the simulation engine 130.

An operator can monitor the execution of the simulation code 190 to verify, that the deployed control logic code 160 is executed correctly and according to desired performance and robustness requirements by means of a human interface to the control programming environment 110.

In a further step 10, after a completed simulation run, the control runtime system 140 can send back a simulation report to the control programming environment 110, so that the operator can verify values recorded over a course of the simulation run and analyze the recorded values for outliers or undesired values. With this information, the operator can improve and optimize the control logic code 160 and perform further tests, based on the same simulation code 190 or an improved simulation code.

Successfully tested control logic code 160 can be deployed into the actual production process, e.g., on embedded controllers.

After successful simulation and testing of the control logic code 160, the generated simulation code 190 can be archived as new, reusable simulation blocks for future reuse.

## Claims

1. A method for generating a simulation code (190) to test a control logic code (160), wherein the control logic code (160) is configured for controlling an automated industrial process, the method comprising:
providing the control logic code (160), wherein the control logic code (160) comprises identifiers, which are related to a plurality of components of the automated industrial process;
generating a simulation generation prompt (170) for a generative artificial intelligence model configured for natural language processing (150), based on the control logic code (160);
performing a similarity search by means of a database (122) and based on the simulation generation prompt (170), wherein the database (122) comprises embeddings of a plurality of elements of a project context (126) of the automatic industrial process;
generating an augmented simulation generation prompt (180), wherein the simulation generation prompt (170) is augmented based on results of the similarity search;
providing the augmented simulation generation prompt (180) to the generative artificial intelligence model (150); and
generating the simulation code (190) for testing the control logic code (160) by means of the generative artificial intelligence model (150), based on the augmented simulation generation prompt (190).

2. The method according to claim 1, wherein
the control logic code (160) comprises identifiers, which are related to a plurality of specifications of an appliance structure of the automated industrial process, wherein the appliance structure comprises a plurality of components and/or subcomponents; and/or wherein
the control logic code (160) comprises identifiers, which are related to a plurality of functional requirements of each component of the automated industrial process; and wherein
the similarity search is performed by means of a vector database (122); and based on the simulation generation prompt (170); wherein the database (122) comprises embeddings of the plurality of specifications of an appliance structure; and/or embeddings of the plurality of functional requirements of each component of the automated industrial process, wherein the augmented simulation generation prompt (180) is augmented based on results of the similarity search.

3. The method according to claim 1 or 2, comprising:
providing a simulation task statement for generating the simulation code (190) for the generative artificial intelligence model (150); and
generating the augmented simulation generation prompt (180) for the generative artificial intelligence model (150), based on the simulation task statement for generating a simulation code and the control logic code (160).

4. The method according to claim 2 or 3, comprising:
providing a plurality of blocks of logic code for process or component simulation for simulating the process of the automated industrial process, wherein the process simulation codes comprises identifiers, which are related to a plurality of components performing the process of the automated industrial process;
generating embeddings of the plurality of blocks of logic code for process or component simulation;
storing the embeddings of the plurality of the blocks of logic code for process or component simulation in the vector database (122);
performing the similarity search by means of the vector database (122) based on the simulation generation prompt (170), based on the embeddings of the plurality of specifications of the appliance structure; and/or based on the embeddings of the plurality of functional requirements of each component of the automated industrial process; and/or based on embeddings of the plurality of the blocks of logic code for process or component simulation.

5. The method according to claim 4, wherein the blocks of logic code for process or component simulation comprises:
code in respect to mechanical-; and/or electrical-; and/or control-behavior and/or control-characteristics of a of component of the plurality of components of the automated industrial process; and/or
code in respect to simulation of a chemical reactions, which are related to the automated industrial process;
particularly for emulating close-to-reality chemical reactions and/or close-to-reality behavior of components of the automated industrial process, for testing the control logic code (160) based on the generated simulation code (190).

6. The method according to any of the preceding claims, comprising:
providing a simulation code syntax, which is feasible for running the generated simulation code (190); and
comparing the generated simulation code (190), which is generated by the generated artificial intelligence model (150), with the simulation code syntax, to verify the simulation code.

7. The method according to any of the preceding claims, comprising:
providing a look up table, which represents a plurality of functionalities the simulation code is required to fulfil for testing the control logic code (160); and
comparing the generated simulation code (190), which is generated by the generative artificial intelligence model (150), with a plurality of functionality requirements for testing the control logic code (160), as provided by the lookup table, to verify the generated simulation code (190).

8. The method according to any of the preceding claims, wherein the generative artificial intelligence model (150) is based on a general generative artificial intelligence model, which is trained by a plurality of pairs of blocks of preassembled control code and associated preassembled simulation logic code, particularly for fine-tuning the generative artificial intelligence model for specific tasks of generating simulation code.

9. The method according to any of the preceding claims, comprising:
partitioning of the augmented simulation generation prompt (180) into a plurality of parts of the augmented simulation generation prompt, particularly to comply with a token limit that is required for an input of the generative artificial intelligence model (150);
generating a plurality of parts of the simulation code, based on the plurality of the parts of the augmented simulation generation prompt; and
assembling the simulation code (190), based on the plurality of the parts of the simulation code.

10. The method according to any one of claims 2 to 9, comprising:
amending the augmented simulation generation prompt (180) with a rule to prioritize the plurality of specifications of an appliance structure of the automated industrial process; and/or the plurality of functional requirements of each component of the automated industrial process, higher than the control logic code (160) for generation of the simulation code (190), particularly to minimize or avoid a risk of overfitting the simulation code (190) to the control logic code (160).

11. The method according to any one of claims 2 to 9, comprising:
providing a series of historical control data, including a plurality of pairs of sensor data related to actuator operation data associated to at least one component of the automated industrial process;
generating embeddings of the plurality of pairs of sensor data assigned to actuator operation data related to at least one component of the automated industrial process; and
storing the embeddings of the plurality of pairs of sensor data and related actuator operation data related to at least one component of the automated industrial process by means of the vector database (122), for augmenting the simulation generation prompt (180) based on the results of the similarity search.

12. A device for generating a simulation code (190) to test a control logic code (160), wherein the control logic code (160) is configured for controlling an automated industrial process, comprising:
a first interface, configured for receiving the control logic code (160);
a database (122), which is configured to store embeddings of a plurality of elements of a project context of the automatic industrial process;
a data processing apparatus, signally coupled to the first interface and/or the database (122);
a second interface, signally coupled to the data processing apparatus (122), wherein the second interface is capable to be coupled to a generative artificial intelligence model configured for natural language processing (150); wherein
the device for generating a simulation code is comprising means and/or the device for generating a simulation code is configured, to carry out one of the methods according to claim 1 to 11.

13. A method for testing control logic code (160), comprising:
providing the control logic code (160);
generating simulation code (190) according to any of the claims 1 to 11;
execute the generated simulation code (190), by means of a simulation engine (130);
execute the control logic code (160), by means of a runtime system (140), which is coupled to the simulation engine (130) to test the control logic code (160).

14. A process-controller for controlling an automated industrial process, comprising:
a programmable logic controller; or a distributed control system of the automated industrial process;
a storage memory, which is coupled to the programmable logic controller; and/or which is coupled to the distributed control system, wherein the storage memory is configured to store a control logic code for the programmable logic controller;
a controller-interface, which is signally coupled to the programmable logic controller; and wherein the controller-interface is configured to be signally coupled to a plurality of components and/or subcomponents of an automated industrial process system; and wherein
the process-controller is configured to control the automatic industrial process, based the control logic code (160), which is tested by a method according to claim 13.

15. Use of a generative artificial intelligence model configured for natural language processing (150) for generating simulation code (190) for testing control logic code (160) according to any of claims 1 to 11.
